(19) Europäisches Patentamt
European Patent Office
Office européen des brevets

(11) **EP 3 046 197 B1**

(12) **EUROPÄISCHE PATENTSCHRIFT**

(45) Veröffentlichungstag und Bekanntmachung des Hinweises auf die Patenterteilung:
**21.03.2018 Patentblatt 2018/12**

(51) Int Cl.:
*H02H 3/16* *(2006.01)*      *G01R 31/08* *(2006.01)*
*H02H 3/38* *(2006.01)*      *H02H 3/42* *(2006.01)*

(21) Anmeldenummer: **15000088.3**

(22) Anmeldetag: **15.01.2015**

(54) **Verfahren und Vorrichtung zur Erkennung der Erdschlussrichtung in einem elektrischen Drehstromnetz**

Method and device for detecting the earth fault direction in a three phase alternating electric current network

Procédé et dispositif de détection de direction de défaut de mise à la terre dans un réseau à courant triphasé

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**20.07.2016 Patentblatt 2016/29**

(73) Patentinhaber: **NSE AG**
**5610 Wohlen (CH)**

(72) Erfinder: **Aebersold, Andreas**
**5622 Waltenschwil (CH)**

(74) Vertreter: **Naiu, Radu Mircea**
**E. Blum & Co. AG**
**Vorderberg 11**
**CH-8044 Zürich (CH)**

(56) Entgegenhaltungen:
**CH-B1- 703 900      DE-A1- 19 901 789**
**DE-B3- 10 302 451**

## Beschreibung

### Hintergrund der Erfindung

Die Erfindung betrifft ein Verfahren zur Erkennung der Erdschlussrichtung in einem kompensiert betriebenen bzw. in einem isoliert betriebenen elektrischen Drehstromnetz. Ferner betrifft die Erfindung für jedes der Verfahren jeweils eine Vorrichtung zur Erkennung der Erdschlussrichtung im elektrischen Drehstromnetz.

### Stand der Technik

Ein erheblicher Teil der Störungen des Betriebes elektrischer Versorgungsnetze der Energieversorger entsteht durch einpolige Fehler und insbesondere Erdschlüsse. Solche können z.B. durch Hineinwachsen oder Umstürzen eines Baumes in eine Freileitung oder durch fehlerhafte Isolationen entstehen. Sogenannte ErdschlussRichtungsrelais melden grundsätzlich auch in vermaschten Netzen selektiv die von Erdschlüssen betroffenen Abgänge. Als Messkriterium dienen dabei der Summennullstrom und die Verlagerungsspannung, aus denen die Erdschlussrichtung ermittelt wird. Bei dieser wattmetrischen Erfassung der Erdschlussrichtung erfolgt diese in einem isoliert betriebenen Netz anders (mit $\sin\varphi$-Relais) als bei kompensiert betriebenen Netzen (mit $\cos\varphi$-Relais). Bei intermittierenden Erdschlüssen versagen indes einfache Erdschluss-Richtungsrelais, da bei einer Neuzündung die Richtung nicht sicher erkannt wird.

Zur Sternpunktbehandlung kann generell das Folgende ausgeführt werden: Im Fall der Entstehung einer elektrisch leitfähigen Verbindung zwischen einem Aussenleiter und dem Erdreich bestimmt die Art der Sternpunktbehandlung das Verhalten des Netzes. Dabei ist es unerheblich, ob es sich bei dem Sternpunkt um einen Transformator oder Generator handelt. Prinzipiell unterscheidet man fünf Arten der Sternpunkterdung (SPE), welche ganz unterschiedliche Ansprüche an die Netzkonzeption stellt.

(1) Starre Sternpunkterdung. Der Sternpunkt wird über eine möglichst impedanzlose Verbindung über eine ausgedehnte Erdungsanlage mit dem Erdpotential verbunden. Als Vorteile ergeben sich keine Spannungsüberhöhungen auf den nicht betroffenen Leitern und die einfache Fehlerortung mit gerichtetem Überstromschutz. Als Nachteile ergeben sich, dass der Erdschluss zum Erdkurzschluss wird, dass sich eine hohe thermische Belastung der Leiter durch Erdkurzschlussströme ergibt, und dass eine hohe Berührungsspannung an der Fehlerstelle möglich ist. Weitere Nachteile sind ein hoher Aufwand für die Erdungsanlage und die Versorgungsunterbrechung durch Abschaltung.

(2) Isolierte Sternpunkterdung. Dabei wird der Quellensternpunkt nicht mit dem Erdreich verbunden. Als Vorteile ergeben sich ein geringerer Aufwand und die geringere Belastung der Leitungen durch den kapazitiven Erdschlussstrom sowie geringere Berührungsspannungen an der Fehlerstelle. Das Netz kann im Erdschlussfall weiter betrieben werden und Lichtbogenfehler können von selbst erlöschen. Als Nachteile ergeben sich Spannungsüberhöhungen auf den nicht vom Fehler betroffenen Leitern um den Faktor $\sqrt{3}$ und bei grossen Kabelnetzen kann der Erdschlussstrom immer noch sehr gross werden. Die Richtungserkennung erfordert ferner spezielle Erdschlussrichtungsrelais.

(3) Niederohmige Sternpunkterdung. Dabei wird der Quellensternpunkt über eine definierte ohmsche Impedanz mit dem Erdpotential verbunden. Diese Variante wird eingesetzt, wenn eine starre Sternpunkterdung zu unzulässigen Erdkurzschlussströmen führt, aber die Spannungsüberhöhung von isoliert betriebenen Netzen nicht akzeptabel ist. Als Vorteile ergeben sich die Begrenzung des Erdkurzschlussstroms und der auftretenden Spannungsüberhöhungen. Ferner ergibt sich eine einfache Fehlerortung mit gerichtetem Überstromschutz. Als Nachteile ergeben sich die Spannungsüberhöhungen auf den nicht vom Fehler betroffenen Leitern und dass der Erdschluss zum Erdkurzschluss wird und somit auch die thermische Belastung der Leiter durch Erdkurzschlussströme. Ferner ist eine erhöhte Berührungsspannung an der Fehlerstelle möglich. Zudem ergibt sich ein hoher Aufwand für die Erdungsanlage und die Versorgungsunterbrechung durch Abschaltung.

(4) Die kurzzeitig niederohmige Sternpunkterdung. Dabei ist der Quellensternpunkt im Normalbetrieb isoliert. Zur Richtungserfassung wird kurzzeitig ein ohmscher Widerstand in den Sternpunkt eingeschaltet und der Erdschluss in einen Erdkurzschluss überführt. Nach der Richtungserkennung und Abschaltung der betroffenen Bereiche wird das Netz wieder isoliert betrieben. Als Vorteile ergeben sich, dass der Erdkurzschlussstrom begrenzt wird und dass eine einfache Fehlerortung mit gerichtetem Überstromschutz möglich ist. Als Nachteile können genannt werden, dass sich eine Spannungsüberhöhung auf nicht vom Fehler betroffenen Leitern um den Faktor $\sqrt{3}$ ergibt und der Erdschluss zum Erdkurzschluss wird. Somit ergibt sich eine thermische Belastung der Leiter durch Erdkurzschlussströme, und auch eine erhöhte Berührungsspannung an der Fehlerstelle ist möglich. Ferner ergibt sich ein hoher Aufwand für die Erdungsanlage sowie eine Versorgungsunterbrechung durch Abschaltung.

(5) Die kompensierte/gelöschte Resonanzsternpunkterdung. Dabei wird der Quellensternpunkt über eine einstellbare Induktivität mit dem Erdpotential verbunden. Die Grösse der Induktivität bzw. Erdschlusslöschspule (nach ihrem Erfinder auch Petersenspule genannt) gibt den Kompensationsstrom vor. Als Vorteile ergeben sich kleinstmögliche Erdschlussströme und kleinstmögliche Berührungsspannung an der Fehlerstelle. Ferner kann das Netz im Erdschlussfall weiter betrieben werden und Lichtbogenfehler können von selbst erlöschen. Als Nachteile können genannt werden: erhöhe Initialkosten und Wartungsaufwand für Erdschlussspule, hoher Aufwand für die Erdungsanlage und Spannungsüberhöhung auf nicht vom Fehler betroffenen Leitern um den Faktor √3. Ferner ein hoher Aufwand für die Erdschlussfehlerrichtungserkennung durch die reduzierten Ströme sowie insbesondere ein Problem mit intermittierenden Erdfehlern.

Im Folgenden wird der Erdschluss im kompensierten Netz genauer erläutert. Wird ein gesundes Drehspannungssystem (Figur 1) im kompensierten Netz durch einen Erdschluss auf Leiter 1 beeinträchtigt, wie in Figur 2 schematisch dargestellt, so kommt es zur Verlagerung des Spannungsdreiecks (Figur 3). Die Verlagerungsspannung (Sternpunkt-Erde-Spannung) $\vec{U}_{NE}$ zeigt dabei von der Mitte des Spannungsdreiecks in Richtung des Erdschlusses (in Figur 3 ist der Vektor für bessere Übersichtlichkeit vom Ursprung aus gezeichnet). Es gilt:

$$\vec{U}_{NE} \;=\; -\frac{1}{3}\cdot\sum\vec{U}_X \;=\; -\frac{1}{3}\cdot\left(\vec{U}_1 + \vec{U}_2 + \vec{U}_3\right) \tag{1}$$

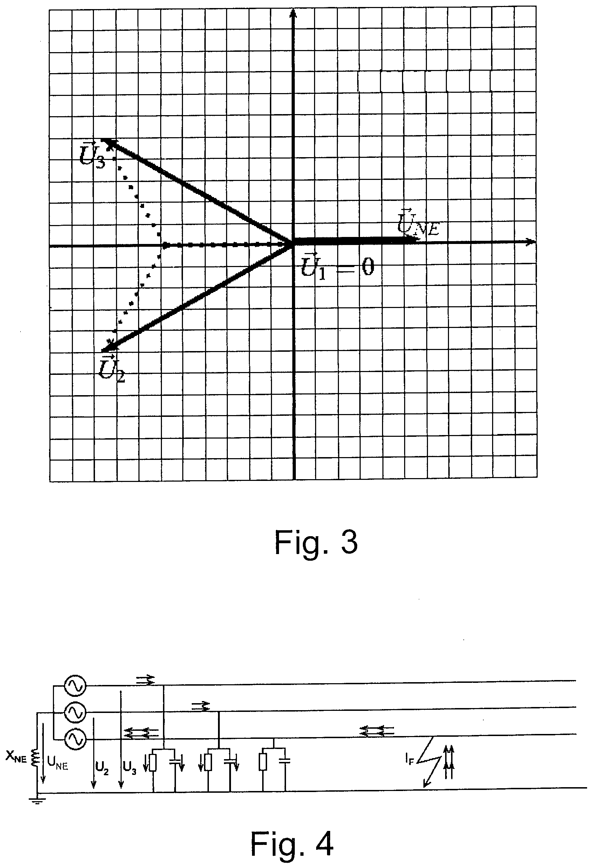

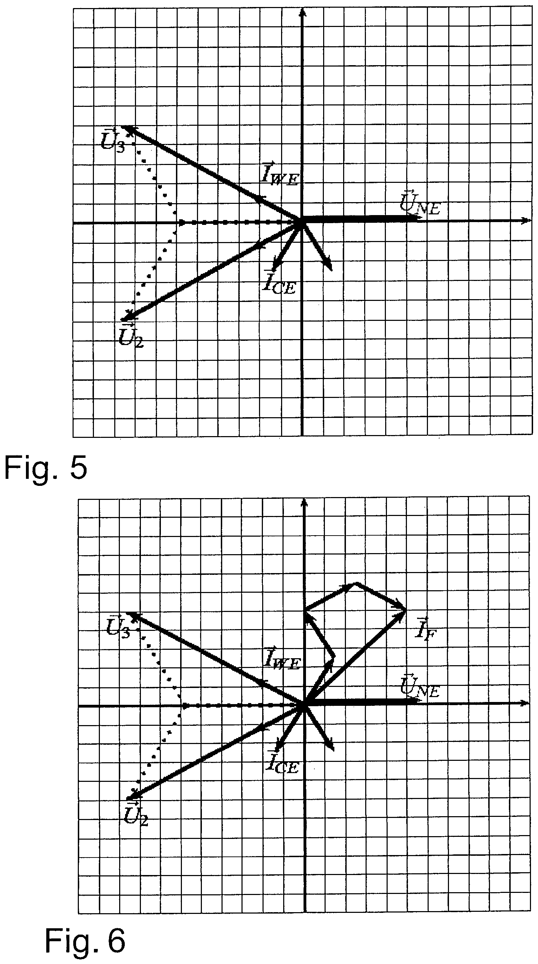

Die Leiter-Erde-Spannungen der gesunden Leiter steigen dabei auf den Wert der verketteten Spannungen an, die genau dem √3-fachen Wert entsprechen. Die überhöhte Leiter-Erde-Spannung treibt durch die Ableitwiderstände und -kapazitäten der Leitung einen Strom in das Erdreich, dessen Summe an der Fehlerstelle als Fehlerstrom $I_F$ in den fehlerhaften Leiter zurückfliesst (Figur 4). Die Leiterströme sind in Figur 5 gezeigt und der Fehlerstrom ist in Figur 6 gezeigt. Dabei ist in Figur 6 der Summenstrom immer noch Null. Erst durch das Hinzufügen eines weiteren Abgangs wird ein Summenstrom messbar, der sich aus den rückfliessenden Strömen der anderen Abgänge zusammensetzt und als $I_E$ bezeichnet wird. Man kann also feststellen, dass die Grösse des gemessenen Summenstromes nicht dem Fehlerstrom entspricht, sondern erst durch benachbarte Abzweige definiert wird. Auf die entsprechende Darstellung wird hier verzichtet.

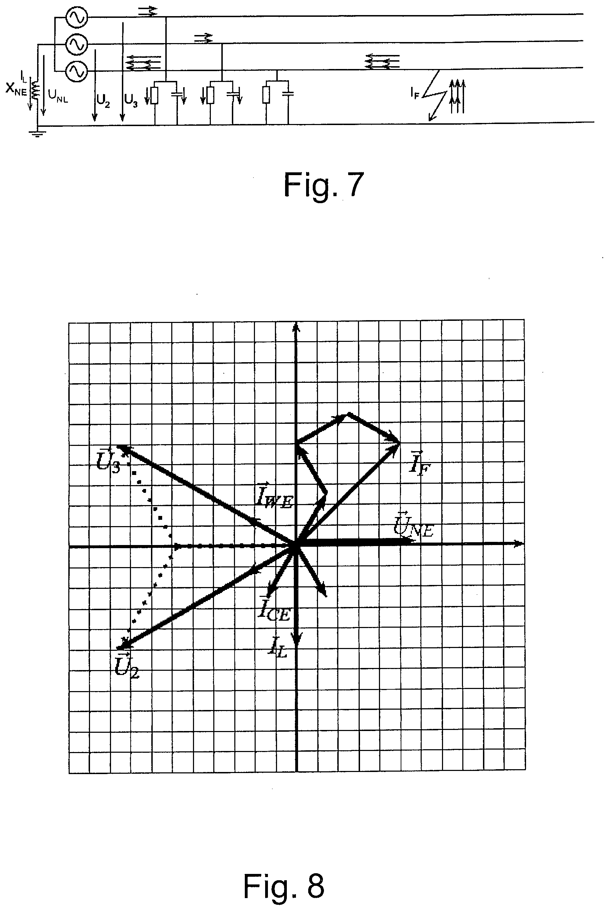

Im kompensierten Netz kommt nun noch der Strom aus der Petersenspule bzw. Erdschlusslöschspule in der Fehlerstelle hinzu. Dieser wird von der Spannung getrieben und liegt zu dieser 90 % nacheilend; die Figuren 7, 8 und 9 zeigen diese Situation. In Abhängigkeit von der Grösse des Kompensationsstromes wird der an der Fehlerstelle fliessende Ladestrom mehr oder weniger kompensiert. Bei idealer Kompensation bleibt nur noch der Wirkreststrom $I_{WR}$ als Strom in der Fehlerstelle übrig. Bekannterweise erfolgt im Erdschlussfall die Richtungserkennung durch die Erkennungs- bzw. Schutzvorrichtungen (Erdschlussrelais) wie folgt:

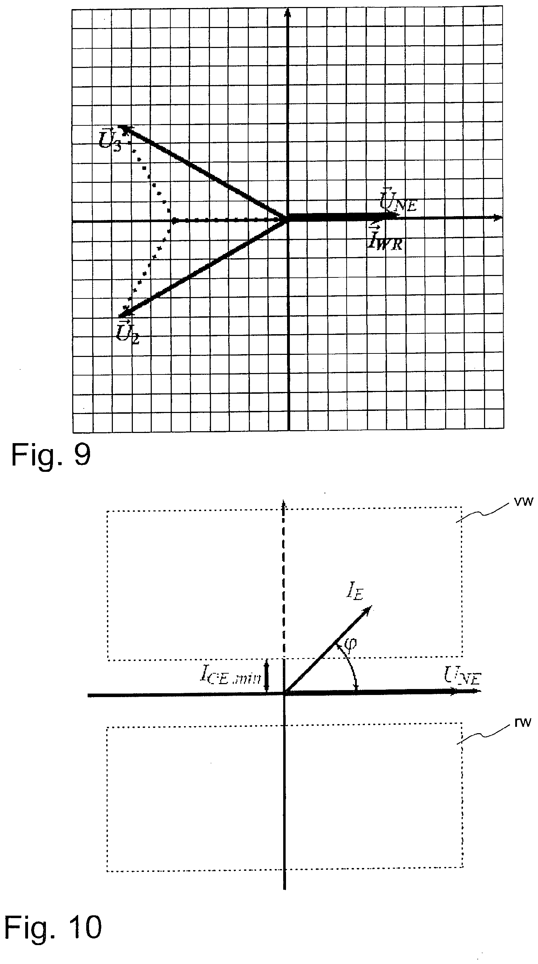

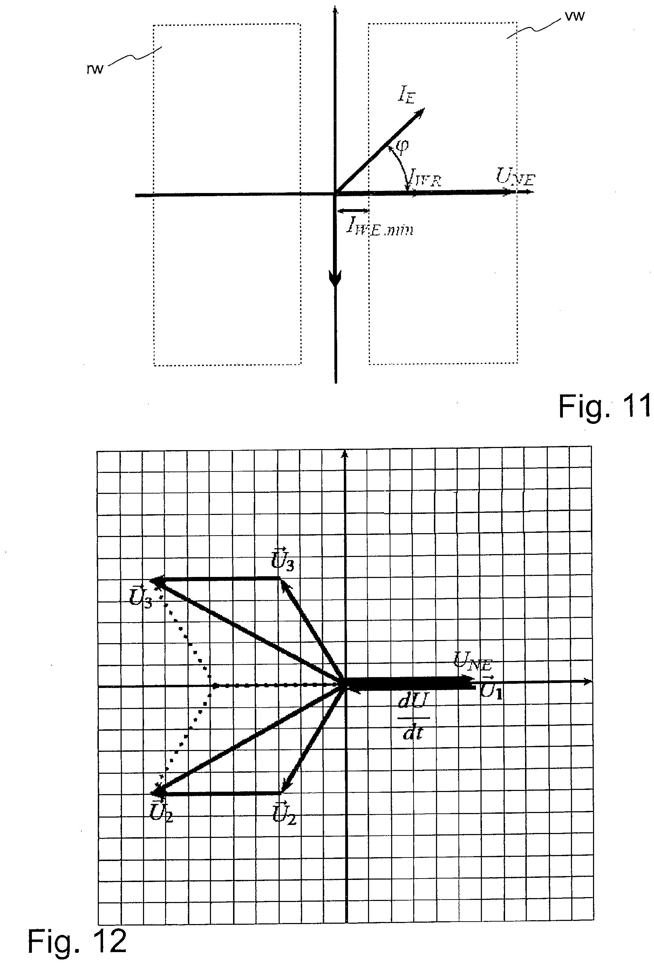

Die dazu in den Figuren 10 und 11 dargestellten Richtungsmerkmale sind durch einfache Gleichungen zu beschreiben. Für die Sinusschaltung:

$$I_E \cdot sin\varphi \;>\; \left|I_{CE,min}\right| \qquad \Rightarrow \texttt{Vorwärts} \tag{2}$$

$$I_E \cdot sin\varphi \;<\; -\left|I_{CE,min}\right| \qquad \Rightarrow \texttt{Rückwärts} \tag{3}$$

Für die Cosinusschaltung:

$$I_E \cdot cos\varphi \;>\; \left|I_{WE,min}\right| \qquad \Rightarrow \texttt{Vorwärts} \tag{4}$$

$$I_E \cdot cos\varphi \;<\; -\left|I_{WE,min}\right| \qquad \Rightarrow \texttt{Rückwärts} \tag{5}$$

Der Winkels $\varphi$ ist der Winkel zwischen Verlagerungsspannung $U_{NE}$ und dem Erdstrom $I_E$ und spielt für die Richtungserkennung eine entscheidende Rolle. Jedoch ist mit diesem Vorgehen nach Stand der Technik eine Richtungserkennung im Fall eines intermittierenden Erdfehlers nicht möglich; solche intermittierende Erdfehler stellen daher ein Problem dar. Isolierte und kompensierte Netze können unter bestimmten Bedingungen im Falle eines Erdschlusses lange weiter betrieben werden. Um den Fehler schnell eingrenzen zu können, werden handelsübliche Erdschlussrichtungsrelais, z.B. wie das DIGISAVE RD, der Fa. NSE GmbH, Schweiz, eingesetzt. Erdschlussrelais erkennen die Richtung des Fehlers, wie oben erläutert, am Winkel zwischen der Verlagerungsspannung $U_{NE}$ und dem Erdschlussstrom $I_E$ und dies wird, wie oben erläutert, in einem kompensierten Netz durch die so genannte Cosinusschaltung, in einem isolierten Netz durch die Sinusschaltung realisiert. In einem kompensierten Netz kann aber der Erdschlussstrom so klein werden, dass der Fehlerlichtbogen augenblicklich wieder erlischt. Dadurch kehrt die Leiterspannung des fehlerhaften Leiters wieder zurück und sobald diese einen kritischen Wert überschreitet, kommt es zur Neuzündung. Dieser Vorgang wird als intermittierender Erdfehler bezeichnet. Das Problem für die Erdschlussrichtungserkennung nach Stand der Technik besteht darin, dass im Moment der Neuzündung ein Umladungsstrom $I_U$ in die zwei gesunden Leiter fliesst. Dieser Impulsstrom hat eine entgegengesetzte Richtung zu der Verlagerungsspannung $U_{NE}$.

$$I_U \sim \frac{dU}{dt} \qquad\qquad\qquad (6)$$

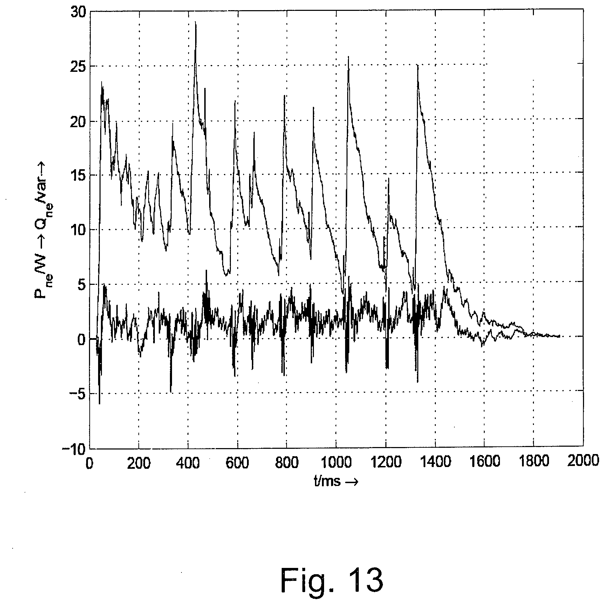

Hierbei handelt es sich um einen Wirkstrom, da im Kondensator gespeicherte Energie erst vom Netz aufgebracht werden muss. Figur 12 zeigt das Zeigerdiagramm des Zündvorganges. Zur Veranschaulichung der Situation bei einem intermittierenden Erdfehler sind die Leistungsverläufe im Nullsystem unter Verwendung von $U_{NE}$ und $I_E$ in Figur 13 dargestellt. Man erkennt, dass die Wirkleistung $P_{NE}$ bei jedem Zündimpuls kurzzeitig das Vorzeichen wechselt. Dabei zeigt die Blindleistung $Q_{NE}$ einen sägezahnförmigen Verlauf. Dadurch, dass der Wirkstrom immer wieder das Vorzeichen wechselt, wechselt ein Erdschlussrichtungsschutz ohne Unterdrückung von intermittierenden Erdfehlern ebenfalls immer wieder die Richtung.

Im Folgenden wird die Berechnung der Wirkenergie bzw. Blindenergie zur Ermittlung der Richtung eines Erdschlussfehlers, insbesondere eines intermittierenden Erdschlussfehlers, erläutert, da dieses Verfahren der vorliegenden Erfindung zugrunde liegt.

Dabei wird so vorgegangen, dass die Richtung an Hand des Vorzeichens der verbrauchten Nullsystemwirkenergie ermittelt wird. Obwohl nämlich beim Zündvorgang des intermittierenden Fehlers die Stromflussrichtung auf die falsche Erdschlussfehlerrichtung deutet, so ergibt sich doch eine mittlere Leistung in Vorwärtsrichtung, so dass bei positivem Vorzeichen der verbrauchten Nullsystemwirkenergie die Vorwärtsrichtung des Erdschlusses angezeigt werden kann, bei negativem Vorzeichen die Rückwärtsrichtung des Erdschlusses.

Die Nullsystemwirkenergie wird wie folgt berechnet

$$E_0 = \sum_{n\,=\,nx\,-\,nFE}^{n_x} u_0(n) \cdot i_0(n) \qquad\qquad (7)$$

Dabei bedeuten die verwendeten Symbole was folgt:

$E_0$      Nullsystemwirkenergie
$u_0(n)$    Nullspannung
$i_0(n)$     Nullstrom
nFE      eingestelltes Integrationszeitfenster in Abtastpunkten
nx        aktueller Zeitpunkt

Gemäss der Erfindung wird nun zur Ermittlung der Erdschlussrichtung im isoliert betriebenen Drehstromnetz so vorgegangen, dass die Richtung an Hand des Vorzeichens der ausgetauschten Nullsystemblindenergie ermittelt wird. Obwohl nämlich beim Zündvorgang des intermittierenden Fehlers die Stromflussrichtung auf die falsche Erdschlussfehlerrichtung deutet, so ergibt sich doch ein Austausch in Vorwärtsrichtung, so dass bei positivem Vorzeichen der ausgetauschten Nullsystemblindenergie die Vorwärtsrichtung des Erdschlusses angezeigt werden kann, bei negativem Vorzeichen die Rückwärtsrichtung des Erdschlusses.

Die Nullsystemblindenergie wird wie folgt ermittelt:

$$E_{b0} = \sum_{n\,=\,nx\,-\,nFE}^{n_x} u_0(n) \cdot i_0(n - N/4) \qquad\qquad (8)$$

Dabei gelten die obigen Symbole sowie ergänzend die folgenden Symbole:

$E_{b0}$ Nullsystemblindenergie
N Anzahl der Abtastpunkte pro Netzperiode (f=50Hz => N=20)

DE 199 01 789 offenbart ein Verfahren zur Erdschlussrichtungsbestimmung in Energieversorgungsnetzen. Dabei wird beim Auftreten eines Erdschlusses aus dem Nullstrom und der Nullspannung die kapazitive Blindleistung ermittelt und aus deren Vorzeichen auf die Richtung des Erdschlusses geschlossen.

CH 703 900 beschreibt ein Verfahren und Vorrichtung zur Erkennung der Erdschlussrichtung in einem elektrischen Drehstromnetz, bei dem in einem kompensiert betriebenen Drehstromnetz das Vorzeichen der Nullsystemenergie betrachtet wird und in einem isoliert betriebenen Drehstromnetz das Vorzeichen der Nullsystemblindenergie.

DE 103 02 451 befasst sich mit einem Verfahren zur Erkennung der Richtung eines Erdschlusses aus der Aufladeschwingung der Erdschlüsse.

Darstellung der Erfindung

Der Erfindung liegt folglich die Aufgabe zu Grunde, die Ermittlung der Erdschlussrichtung bei intermittierenden Erdschlussfehlern in Bezug auf Zuverlässigkeit weiter zu verbessern.

Diese Aufgabe wird bei dem eingangs genannten Verfahren mit den Merkmalen der unabhängigen Verfahrensansprüche jeweils für kompensiert bzw. für isoliert betriebene Drehstromnetze gelöst. Bei den eingangs genannten Vorrichtungen wird die Aufgabe mit den Merkmalen der unabhängigen Vorrichtungsansprüche entsprechend für kompensiert bzw. für isoliert betriebene Drehstromnetze gelöst.

Es hat sich gezeigt, dass die vorliegende Erfindung eine Verbesserung der Zuverlässigkeit der Detektion von Erdschlüssen und deren Richtung herbeiführt. Ferner ist es möglich einen Erdschluss zu identifizieren und zu lokalisieren ohne dass der genaue Zeitpunkt des Fehlereintritts bekannt ist.

Bevorzugte Ausgestaltungen des Verfahrens und der Vorrichtung sind in den abhängigen Ansprüchen definiert und diese und weitere Ausgestaltungen werden an Hand der nachfolgenden Beschreibung erläutert.

Kurze Beschreibung der Zeichnungen

Im Folgenden wird der Stand der Technik und werden Ausführungen der Erfindung anhand der Figuren näher erläutert. Dabei zeigt

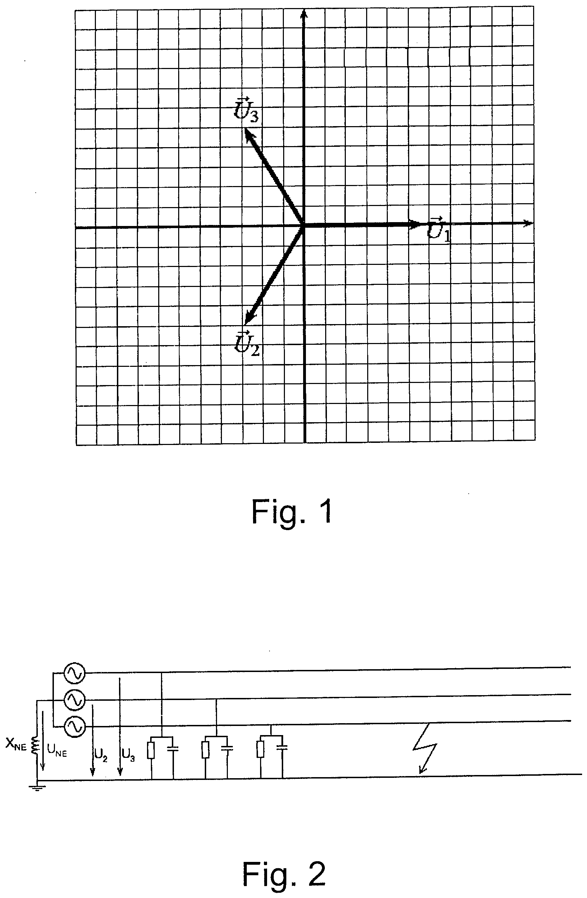

Fig. 1 ein Zeigerdiagramm des gesunden Netzes;
Fig. 2 ein Netzmodell mit Erdschluss;
Fig. 3 ein Zeigerdiagramm des Netzes mit Erdfehler;
Fig. 4 das Netzmodell mit Stromverteilung ohne Kompensationsstrom;
Fig. 5 die Leiterströme zu Figur 4 im Zeigerdiagramm;
Fig. 6 den Fehlerstrom im Zeigerdiagramm;
Fig. 7 das Netzmodell mit Kompensationsstrom;
Fig. 8 die Leiterströme zu Figur 7 im Zeigerdiagramm;
Fig. 9 den Fehlerstrom im Zeigerdiagramm;
Fig. 10 ein Zeigerdiagramm zur Sinusschaltung;
Fig. 11 ein Zeigerdiagramm zur Cosinusschaltung;
Fig. 12 das Zeigerdiagramm des Zündvorgangs beim intermittierenden Erdschluss;
Fig. 13 die Nullsystemleistungen,

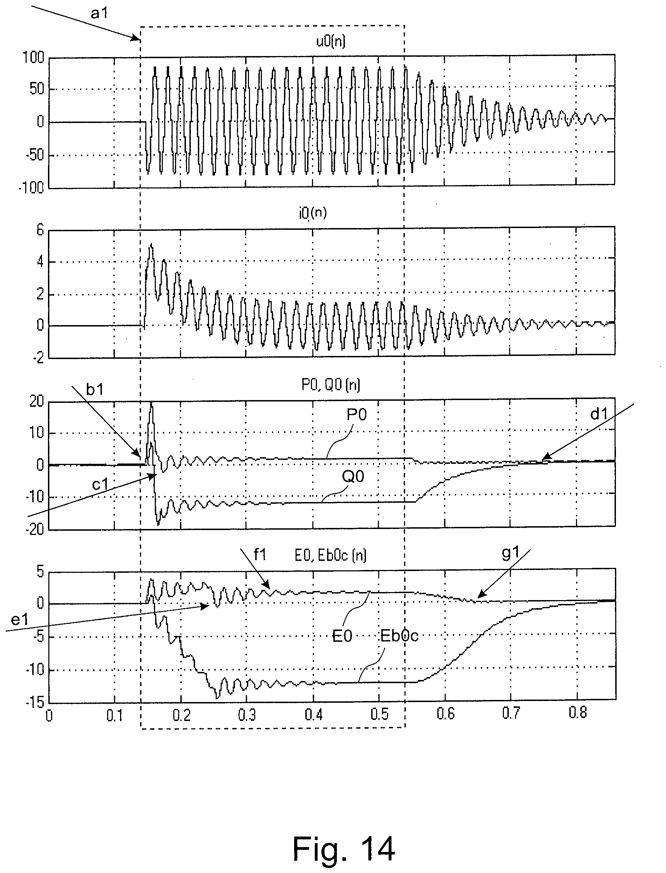

Fig. 14 ein Diagramm mit einem zeitlichen Verlauf relevanter Grössen bei Simulation eines Erdfehlers,

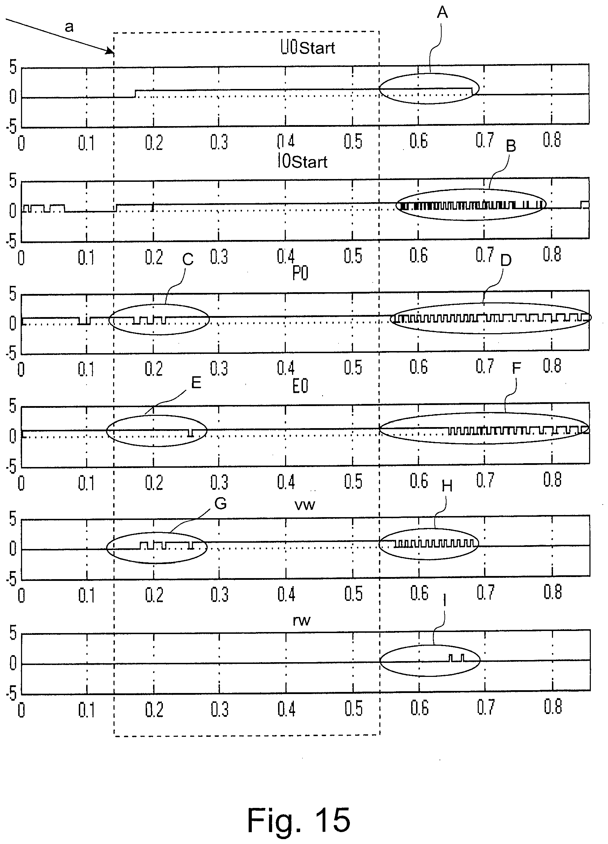

Fig. 15 ein Diagramm mit einem Verlauf relevanter Grössen bei der Simulation aus Fig. 14 ohne Anwendung der Erfindung, und

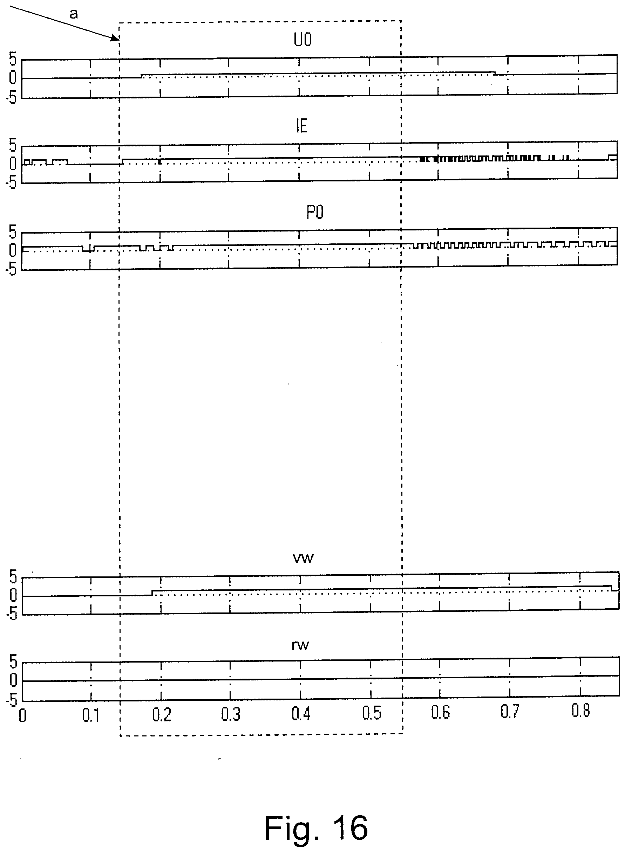

Fig. 16 ein Diagramm mit einem Verlauf der relevanten Grössen bei der Simulation aus Fig. 14 mit Anwendung der Erfindung.

Wege zur Ausführung der Erfindungen

Im Folgenden wird näher auf die Figuren 14 bis 16 eingegangen. Die Figuren 1 bis 13 erläutern den Stand der Technik und wurden im entsprechenden Abschnitt behandelt.

Fig. 14 zeigt ein Diagramm mit einem zeitlichen Verlauf relevanter Grössen bei Simulation eines Erdfehlers in Vorwärtsrichtung in einem kompensiert betriebenen Drehstromnetz. In den Diagrammen sind einige Stellen der Kurven, die besonderer Beachtung bedürfen, mittels Pfeilen oder Kreisen markiert. Mit dem Bezugszeichen a1 wird das Zeitfenster vom Beginn eines Erdfehlers in einem Abgang (einpoliger Erdfehler) bis zu seinem Ende bezeichnet, was für die nächsten Figuren auch gilt. Dabei wird in den Figuren die Amplitude des entsprechenden Signals über die Zeit (in Sekunden) dargestellt.

In den oberen zwei Teilen des Diagramms aus Fig. 14 sind die Verläufe der Nullspannung U0(n) und des Nullstroms I0(n) gezeigt, wobei n diskrete Zeitpunkte bezeichnet. Beim Nullstrom ist auch ein von der Petersenspule herrührender abklingender Gleichstromanteil von I0 berücksichtigt.

Der dritte Teil des Diagramms zeigt den Verlauf der Leistung P0(n) bzw. der Ladung Q0(n). Der Pfeil b1 zeigt dass die Leistung P0 bei Beginn des Erdfehlers richtigerweise positiv ansteigt, jedoch im weiteren Verlauf eine abklingende Schwingung vollzieht (Pfeil c1), wobei das Vorzeichen der Leistung P0 während dieses Einschwingvorgangs maximal für ca. 10 ms häufig negativ wird. Anschliessend stabilisiert sich die Leistung auf einen kleinen positiven Wert. Nach Ende des Erdschlusses verringert sich der Wert der Leistung P0, jedoch wechselt ihr Vorzeichen laufend (Pfeil d1).

Der unterste Teil des Diagramms zeigt den Verlauf der Wirkenergie E0. Der Verlauf der Energie E0 folgt dem Verlauf der Leistung P0 und weist daher auch den kurzzeitigen Vorzeichenwechsel (Pfeil e1). Die Energie E0 wird also auch negativ, jedoch wie im Falle der Leistung P0 nur für maximal ca. 10 ms in diesem Beispiel. Nach etwa 100 ms (Pfeil f1) stabilisiert sich die Energie auf einen korrekten positiven Wert. Ca. 100 ms nach Ende des Erdschlusses sinkt die Energie E0 auf einen sehr kleinen Wert (Pfeil g1).

Es wird angemerkt, dass die in Fig. 14 dargestellten Verläufe der Blindleistung Q0 und der Blindenergie Eb0c sind nur für isolierte Sternpunkterdung relevant.

Fig. 15 zeigt ein Diagramm mit einem Verlauf relevanter Grössen bei der Simulation aus Fig. 14 ohne Anwendung der Erfindung. Dabei werden alle. Werte als Binärwerte dargestellt.

Die oberen zwei Teile des Diagramms zeigen Indikatoren (Flaggen) für die Nullspannung U0 und den Nullstrom I0 an (U0_Start, I0_Start). Entsprechend Fig. 14 liegt die Nullspannung U0 noch für ca. 100 ms nach Ende des Erdschlusses noch an (Kreis A). Die Messung des Nullstroms zeigt sich instabil (vgl. Kreis B) entsprechend der Leistung P0 (Kreis D), was durch die Wechsel der Nullstromflagge sichtbar ist.

Entsprechend Fig. 14 nimmt die Leistung P0 während des Einschwingvorgangs auch negative Werte an (Kreis C). Nach Ende des Erdschlusses wechselt das Vorzeichen der Leistung P0 zunächst mit 100 Hz, da die Periodendauer der Leistung 100 Hz beträgt (sichtbar im Diagramm e.g. bei 0.7 Sekunden), und später mit 50 Hz wegen der 50 Hz Periode der Nullspannung bei Gleichstrom.

Im vierten Teil des Diagramms ist der Verlauf der Energie E0 dargestellt. Entsprechend Fig. 14 nimmt die Energie nach ca. 100 ms einen negativen Wert an (Kreis E) und folgt dem Verlauf der Leistung P0 nach Ende des Erdschlusses (Kreis F).

Der fünfte Teil des Diagramms zeigt den Vorwärts-Richtungsentscheid (vw). Dabei wird klar, dass dieser im Anfangsbereich des Erdschlusses instabil ist (Kreis G). Eine Ursache dafür ist der Vorzeichenwechsel der Leistung P0, wobei die Instabilität des Entscheids im Bereich von 0.2 Sekunden im Diagramm gezeigt ist. Eine zweite Ursache ist der Vorzeichenwechsel der Energie E0 bei ca. 0.26 Sekunden. Ferner ist der Vorwärtsentscheid nach Ende des Erdschlusses wegen des Rückfalls des Nullstroms I0 (vgl. I0_Start Flagge) auch instabil (Kreis H).

Der sechste Teil des Diagramms zeigt den Rückwärts-Richtungsentscheid (rw). Dieser ist im Bereich nach Ende des Erdschlusses aufgrund der Vorzeichenwechsel der Leistung P0 bzw. der Energie E0 und da die Flagge U0 zu diesen Zeitpunkten noch ansteht, zeitweise falsch (Kreis I). Ursache dafür ist das langsame Verschwinden von Nullspannung und Nullstrom nach Erdschlussende, wobei sich eine für die Richtungsbestimmung nicht relevante Leistung P0 bzw. Energie E0 ergibt.

Die vorliegende Erfindung räumt die oben genannten Unsicherheiten der Fehlerbewertung aus, was in Fig. 16 dargestellt ist.

Fig. 16 zeigt ein Diagramm mit einem Verlauf der relevanten Grössen bei der Simulation aus Fig. 14 mit Anwendung der Erfindung.

Die oberen drei Teile des Diagramms entsprechen den bereits erläuterten Zuständen der Strom- bzw. Spannungsflaggen und der Leistung P0. Die unteren zwei Teile des Diagramms zeigen die Richtungsentscheide jeweils für die Vorwärts-Richtung (vw) und für die Rückwärts-Richtung (rw). Wie daraus zu entnehmen ist, findet bei dem vorliegenden Beispiel eines Vorwärts-Erdschlussfehlers auch in der Einschwingzeitspanne am Anfang des Fehlers und in der Zeit unmittelbar nach Ende des Fehlers eine richtige Entscheidung der Erdschlussrichtung statt.

Im Folgenden wird das Verfahren der Erfindung näher erläutert. Dabei wird als Beispiel wieder nur das kompensierte Drehstromnetz herangezogen, da die damit verbundenen Überlegungen für isolierte Netze, bei denen die Blindleistung betrachtet wird, gleichermassen gelten.

Das Verfahren zur Ermittlung eines Erdschlusses und der Erdschlussrichtung in einem kompensiert betriebenen Drehstromnetz umfasst die nachfolgend beschriebenen Schritte.

In einem ersten Schritt a) werden Wertepaare einer Nullspannung U0 und eines Nullstroms I0 fortlaufend gemessen, wobei die Wertepaare jeweils einem Messzeitpunkt zugeordnet sind. Die Messung erfolgt mit einer vorgegebenen Abtastrate. Die Abtastrate wird vorzugsweise vor einer ersten Messung des Nullstroms und der Nullspannung eingestellt und beträgt bevorzugt eine Millisekunde. Entsprechend dem Nyquist-Shannon-Abtasttheorem ist vor der Abtastung ein Tiefpassfilter zur Vermeidung von Artefakten durch höhere Signalfrequenzanteile anzuwenden, auf das hier nicht weiter eingegangen wird.

Im Schritt a) wurde auch das Speichern der ermittelten Wertepaare und des zugeordneten Messzeitpunkts zusammengefasst.

In einem Schritt b) wird die Wirkenergie dadurch gebildet, dass zunächst ein Produkt der gemessenen Nullspannung und des gemessenen Nullstroms jeweils für jeden Messzeitpunkt fortlaufend berechnet und anschliessend eine Summation der Produkte erfolgt. Dabei wird die Summe aus einem Produkt, das dem aktuellsten Messzeitpunkt zugeordnet ist, und einer Anzahl vorangehender Produkte, gebildet. Es wird in diesem Zusammenhang angemerkt, dass bei der Summenbildung im vorliegenden Zusammenhang die dem aktuellsten Messzeitpunkt zugeordneten Grössen immer als einbezogen gelten sollen.

Für die Summenbildung wird die Summe aus Schritt b) dadurch ermittelt, dass bei jeder Berechnung das Produkt, das dem aktuellsten Messzeitpunkt zugeordnet ist, zur Summe aufsummiert und ein ältestes Produkt der Summe herausgerechnet wird. Die Summe wird aus einer einstellbaren, konstanten Anzahl von Wertepaaren gebildet. Mit anderen Worten wandert ein konstantes Integrationsfenster der Breite nFE nach rechts auf der Abszisse (vgl. Fig. 16). Folglich entspricht der für die Summe früheste in Betracht gezogene Messzeitpunkt nx - nFE, wobei nx der aktuellste Messzeitpunkt ist. Folglich wird die Summe über die Spanne vom Zeitpunkt nx-nFE bis nx gebildet (vgl. Gleichung 7).

In einem Schritt c) wird für den aktuellsten Messzeitpunkt die Spannungsflagge $U0_{Start}$ auf 1 gesetzt, wenn die zugeordnete Nullspannung U0 grösser als ein erster Schwellwert ist und sonst auf 0 und eines Stromflags $I0_{Start}$ auf 1 wenn der zugeordnete Nullstrom I0 grösser als ein zweiter Schwellwert ist und sonst auf 0. Der erste und/oder der zweite Schwellwert werden vorzugsweise vor einer ersten Messung des Nullstroms I0 und der Nullspannung U0 eingestellt.

In einem Schritt d) wird eine boolesche UND-Verknüpfung aus dem Spannungsflag $U0_{Start}$ und dem Stromflag $I0_{Start}$, jeweils für den aktuellsten Messzeitpunkt, gebildet. An dieser Stelle wird entschieden ob ein Erdschluss vorliegt; bei einem Resultat gleich 0 liegt kein Erdschluss vor und bei einem Resultat gleich 1 liegt ein Erdschluss vor. Diese Startbedingung für die Auswertung des Energiekriteriums birgt jedoch aus den nachfolgenden Gründen eine Unsicherheit. Bei Erdschlussbeginn kann die Startbedingung wegen der verwendeten Leistung wiederholt für ca. 5 bis 10 ms zurückfallen (vgl. Fig. 15, Kreis C in Zusammenschau mit Kreis G). Bei Erdschlussende verschwindet sie erst nach Ablauf des Integrationsfensters vollständig und neigt während der Fensterdauer zu periodischem Ansprechen mit Frequenzen von 50 oder 100 Hz (vgl. Fig. 15, Kreis D in Zusammenschau mit Kreis H).

Um dem Problem bei Erdschlussbeginn zu begegnen wird ein Resultat der booleschen UND-Verknüpfung um ein erstes Zeitintervall ansprechverzögert. Das erste Zeitintervall wird vor einer ersten Messung des Nullstroms und der Nullspannung eingestellt. Bevorzugt beträgt es 15 ms. Dadurch wird es möglich, die Entscheidungsunsicherheiten aufgrund der Vorzeichenwechsel während des Einschwingvorgangs, was im Zusammenhang mit Fig. 15 erläutert wurde, zu überwinden, denn ein Resultat von 1 (Erdschluss liegt vor) wird nur übernommen, wenn das erste Zeitintervall verstrichen ist, ohne dass das Resultat während dieser Zeit wieder auf 0 zurückgefallen ist. Im letzteren Fall läuft das erste Zeitintervall von neuem an und es wird angenommen, dass kein Erdschluss vorliegt, wie im normalen Fall eines Resultats gleich 0.

Um dem Problem bei Erdschlussende zu begegnen wird das Resultat um ein zweites Zeitintervall rückfallverzögert. Das zweite Zeitintervall wird vor einer ersten Messung des Nullstroms und der Nullspannung eingestellt. Bevorzugt beträgt es 15 ms. Analog wie bei der Ansprechverzögerung wird es dadurch möglich, die Entscheidungsunsicherheiten aufgrund der Vorzeichenwechsel am Erdschlussende, was im Zusammenhang mit Fig. 15 erläutert wurde, zu überwinden, denn ein Resultat von 0 (Erdschluss liegt nicht mehr vor) wird nur übernommen, wenn das zweite Zeitintervall verstrichen ist, ohne dass das Resultat während dieser Zeit wieder auf 1 zurückgefallen ist. Im letzteren Fall läuft das zweite Zeitintervall von neuem an und es wird angenommen, dass immer noch ein Erdschluss vorliegt, wie im normalen Fall eines Resultats gleich 1.

Wenn nun die Entscheidung dass ein Erdschluss vorliegt mit Sicherheit getroffen wurde, werden in einem Schritt e) die Schritte a) bis d) weiter ausgeführt und das Vorzeichen der bis zum aktuellsten Messzeitpunkt berechneten Wirkenergie wird überprüft. In diesem Zusammenhang wird angemerkt, dass die Schritte a) bis d) immer durchgeführt werden, unabhängig ob ein Erdschluss vorliegt oder nicht und unabhängig davon, ob ein Erdschlussende festgestellt worden ist. Ein Resultat der Überprüfung wird um ein drittes Zeitintervall ansprechverzögert und um ein viertes Zeitintervall rückfallverzögert. Das dritte Zeitintervall und/oder das vierte Zeitintervall werden vor einer ersten Messung des Nullstroms und der Nullspannung eingestellt. Vorzugsweise werden beide Zeitintervalle aus einem Bereich zwischen 30 ms und 2000 ms gewählt, wobei ein Wert von 300 ms für ein kompensiertes Drehstromnetz und ein Wert von 50 ms für ein isoliertes Drehstromnetz bevorzugt werden. Die Spanne der Zeitintervalle begründet sich durch die Möglichkeit des Auftritts eines intermittierenden Fehlers.

Bei intermittierenden Fehlern treten im kompensierten Netz längere Pausen zwischen den aufeinander folgenden Erdschlüssen auf (z.B. in der Größenordnung 100 ms), entsprechend der sich wieder aufbauenden Spannung nach Verlöschen des Lichtbogens. Je kleiner die Verstimmung ist, umso länger dauert das Wiederkehren der Spannung.

Bei intermittierenden Fehlern im isolierten Netz sind die Pausen zwischen den aufeinander folgenden Erdschlüssen meistens kurz (z.B. in der Größenordnung 10 ms), weil die Spannung sofort wiederkehrt und damit auch ein sofortiges Wiederzünden des Lichtbogens erfolgt.

Daher werden die Richtungsentscheide rückfallverzögert ausgegeben, wie erwähnt je nach Netz z.B. im Bereich 30 bis 2000 ms.

Das dritte und das vierte Zeitintervall des Richtungsentscheids werden daher für intermittierende Fehler vorzugsweise parametrierbar gewählt. Alternativ werden sie entsprechend der Einstellung isoliert/kompensiert gewählt. Das dritte und das vierte Zeitintervall werden dabei entsprechend der Dauer der erdschlussfreien Pause gewählt.

Als letzten Schritt f) wird mindestens aufgrund des Vorzeichens der Wirkenergie entschieden, ob die Erdschlussrichtung als "Vorwärts", im Falle eines positiven Vorzeichens, oder als "Rückwärts", im Falle eines negativen Vorzeichens, gemeldet wird. Es wird angemerkt dass eine Meldung der Erdschlussrichtung als "Vorwärts" im Falle eines negativen Vorzeichens und als "Rückwärts" im Falle eines positiven Vorzeichens gleichwertig ist, wenn das unterschiedliche Vorzeichen lediglich durch die Betrachtungsweise der Richtung des Spannungsvektors gegeben ist.

Es ist bevorzugt, zusätzlich zur Entscheidung aufgrund des Vorzeichens der Wirkenergie oder der Blindenergie eine Überprüfung eines Vorzeichens der Leistung P0 durch Integration der Produkte der Nullspannung und des Nullstroms über eine Periode der Netzfrequenz, die den aktuellsten Messzeitpunkt einschliesst, durchzuführen, wobei die Erdschlussrichtung bei Übereinstimmung der Vorzeichen der Wirkenergie oder Blindenergie und der Leistung P0 bestätigt wird. Dies ist darauf zurückzuführen, dass die Leistung in vielen Fällen die Richtung mit einer Frequenz von ca. 100 Hz ändert. Daher kann die Leistungsrichtung zur Freigabe des Energiekriteriums verwendet werden, z.B. wenn die Leistung mittlerweile ihre Richtung geändert hat aber das Integral der Energie noch nicht abgeklungen ist.

Die Meldung der Erdschlussrichtung wird vorzugsweise durch das Setzen oder Nichtsetzen von Vorwärts-Flaggen bzw. Rückwärts-Flaggen in einem Speicher durchgeführt. Auf der Basis dieser Flaggen kann beispielsweise als Reaktion auf die Feststellung eines Erdschlusses, im vorliegenden Beispiel eines Vorwärts-Erdschlusses, der betreffende Netzabschnitt beispielsweise durch eine entsprechende Anweisung an einen Leistungsschalter vom übrigen Netz getrennt werden.

Es erweist sich für die Ausführung als vorteilhaft, wenn die Meldung nur bei Überschreitung eines Mindestwertes des Wirkreststromes $I_{WE}$ (zweiter Schwellenwert) im kompensierten Netz erfolgt bzw. bei Überschreitung eines Mindestwertes des kapazitiven Erdschlussstromes $I_{CE}$ (zweiter Schwellenwert) im isolierten Netz. Die Mindestwerte sollen wählbar einstellbar sein. Bevorzugt werden die Werte $I_{WE}$ bzw. $I_{CE}$ wie folgt aus $E_0$ bzw. aus $E_{b0}$ ermittelt:

$$U_{NE,\Sigma} = \sqrt{\frac{1}{nFE} \sum_{nx}^{n_x} - nFE \; u_{NE}^2 (n)} \qquad (9)$$

$$I_{WE} = \frac{E_0}{U_{NE,\Sigma}} \qquad (10)$$

$$I_{CE} = \frac{E_{b0}}{U_{NE,\Sigma}} \qquad (11)$$

Die logische Verknüpfung der Grössen kann wie folgt dargestellt werden, wobei immer gilt, dass ein Erdschluss vorliegt und dass die Nullspannung grösser als der Einstellwert ist. Bevorzugt werden die Meldungen als Vorwärts-Flagge bzw. Rückwärts-Flagge in einem Speicher gesetzt.

Für das kompensierte Netz gilt dann:

$I_{WE}$ > Einstellwert, $E_0$ > 0 => Vorwärts-Flagge setzen.
$I_{WE}$ > Einstellwert, $E_0$ < 0 => Rückwärts-Flagge setzen.
$I_{WE}$ < Einstellwert => keine Richtungs-Flagge setzen.

Für das isolierte Netz gilt entsprechend:

$I_{CE}$ > Einstellwert, $E_{b0}$ > 0 => Vorwärts-Flagge setzen.
$I_{CE}$ > Einstellwert, $E_{b0}$ < 0 => Rückwärts-Flagge setzen.
$I_{CE}$ < Einstellwert => keine Richtungs-Flagge setzen.

Bevorzugt werden als Richtungsindikatoren für "Vorwärts", "Rückwärts" oder "Keine Richtung" somit Flaggen gesetzt, was in einem Speicher, insbesondere in einem Ringspeicher erfolgt, der eine Länge $t_{flag}$ aufweist. Für jeden Abtastzeitpunkt nx wird der Richtungsindikator ermittelt und die entsprechende Flagge im Ringspeicher abgelegt. Die dann für den Schutz des Netzes ermittelte Erdschlussfehlerrichtung wird bevorzugt in einem zweiten Speicher hinterlegt. Zu jedem Zeitpunkt wird dieser Speicher mittels des Verfahrens aktualisiert, indem geprüft wird, ob alle Richtungsmeldungen bzw. Richtungsindikatoren im ersten Speicher bzw. im Ringspeicher dieselbe Richtung anzeigen. Wenn dies der Fall ist, wird diese Richtung in den zweiten Speicher bzw. den Anzeigespeicher übernommen, ansonsten wird der zweite Speicher nicht verändert und der alte Wert beibehalten. Standardmässig wird der zweite Speicher mit "Keine Richtung" initialisiert.

Das Integrationszeitfenster nFE wird auf das aktuell zu schützende Netz eingestellt, was durch Versuche oder ausgehend von einem Grundwert als Optimierung im Betrieb erfolgen kann. Vorzugsweise erfolgt die Abschätzung der geeigneten Integrationszeitfenster auf Grund einer Analyse des Netzes und insbesondere auf Grund vorhandener Erdschlussaufzeichnungen.

Die Verfahren und die Vorrichtungen ergibt die Möglichkeit in isoliert betriebenen Netzen und in kompensiert betriebenen Netzen intermittierende Erdfehler richtig zu erkennen, bei denen einfache Erdschlussrichtungsrelais versagen, da bei einer Neuzündung die Richtung falsch angezeigt wird. Durch die Betrachtung der Wirk- und Blindenergie im Nullsystem ist es dahingegen möglich, diesen Effekt zu unterdrücken.

Wie eingangs erwähnt hängt das Zeitverhalten der Fehlerfunktion stark von den Filter- bzw. Integrationsalgorithmen ab, so dass unter Umständen falsche Richtungsentscheide ausgegeben werden. Im Folgenden wird die Erfindung auf der Basis des obigen Verfahrens beschrieben.

Obwohl bevorzugte Ausführungsformen der Erfindung in diesem Dokument beschrieben wurden, wird darauf hingewiesen, dass die Erfindung nicht auf diese beschränkt ist und kann vielmehr auf andere mannigfaltige Weisen im Rahmen der nun nachfolgenden Ansprüche ausgeführt werden. Folglich sind Begriffe wie "bevorzugt", "insbesondere", "vorteilhaft" nur im Zusammenhang mit Optionen und Beispielen aufzufassen.

## Patentansprüche

1. Verfahren zur Ermittlung eines Erdschlusses und der Erdschlussrichtung in einem kompensiert betriebenen Drehstromnetz, **gekennzeichnet durch** die Schritte:

    a) fortlaufendes Messen von Wertepaaren einer Nullspannung und eines Nullstroms, welche Wertepaare jeweils einem Messzeitpunkt zugeordnet sind, mit einer vorgegebenen Abtastrate, und Speichern der ermittelten Wertepaare und des zugeordneten Messzeitpunkts,

    b) fortlaufendes Berechnen der Wirkenergie durch Bildung eines Produkts der gemessenen Nullspannung und des gemessenen Nullstroms jeweils für jeden Messzeitpunkt und Bildung einer Summe aus einem Produkt, das dem aktuellsten Messzeitpunkt zugeordnet ist, und einer Anzahl vorangehender Produkte,

    c) Setzen für den aktuellsten Messzeitpunkt einer Spannungsflagge auf 1 wenn die zugeordnete Nullspannung grösser als ein erster Schwellwert ist und sonst auf 0 und einer Stromflagge auf 1 wenn der zugeordnete Nullstrom grösser als ein zweiter Schwellwert ist und sonst auf 0,

    d) Bilden einer booleschen UND-Verknüpfung aus der Spannungsflagge und der Stromflagge, jeweils für den aktuellsten Messzeitpunkt, wobei ein Resultat der booleschen UND-Verknüpfung um ein erstes Zeitintervall ansprechverzögert und um ein zweites Zeitintervall rückfallverzögert ist, wobei bei einem Resultat gleich 0 kein Erdschluss vorliegt und bei einem Resultat gleich 1 ein Erdschluss vorliegt, und
    wenn ein Erdschluss vorliegt

    e) weiteres Ausführen der Schritte a) bis d) und Überprüfen des Vorzeichens der bis zum aktuellsten Messzeitpunkt berechneten Wirkenergie, wobei ein Resultat der Überprüfung um ein drittes Zeitintervall ansprechverzögert und um ein viertes Zeitintervall rückfallverzögert ist, und

    f) Entscheiden mindestens aufgrund des Vorzeichens der Wirkenergie ob die Erdschlussrichtung als "Vorwärts", im Falle eines positiven Vorzeichens, oder als "Rückwärts", im Falle eines negativen Vorzeichens, gemeldet wird.

2. Verfahren zur Ermittlung eines Erdschlusses und der Erdschlussrichtung in einem isoliert betriebenen Drehstromnetz, **gekennzeichnet durch** die Schritte:

    a) fortlaufendes Messen von Wertepaaren einer Nullspannung und eines Nullstroms, welche Wertepaare jeweils einem Messzeitpunkt zugeordnet sind, mit einer vorgegebenen Abtastrate, und Speichern der ermittelten Wertepaare und des zugeordneten Messzeitpunkts,

    b) fortlaufendes Berechnen der Blindenergie durch Bildung eines Produkts der gemessenen Nullspannung und des gemessenen Nullstroms jeweils für jeden Messzeitpunkt und Bildung einer Summe aus einem Produkt, das dem aktuellsten Messzeitpunkt zugeordnet ist, und einer Anzahl vorangehender Produkte,

    c) Setzen für den aktuellsten Messzeitpunkt einer Spannungsflagge auf 1 wenn die zugeordnete Nullspannung grösser als ein erster Schwellwert ist und sonst auf 0 und einer Stromflagge auf 1 wenn der zugeordnete Nullstrom grösser als ein zweiter Schwellwert ist und sonst auf 0,

    d) Bilden einer booleschen UND-Verknüpfung aus der Spannungsflagge und der Stromflagge, jeweils für den aktuellsten Messzeitpunkt, wobei ein Resultat der booleschen UND-Verknüpfung um ein erstes Zeitintervall

9

ansprechverzögert und um ein zweites Zeitintervall rückfallverzögert ist, wobei bei einem Resultat gleich 0 kein Erdschluss vorliegt und bei einem Resultat gleich 1 ein Erdschluss vorliegt, und

wenn ein Erdschluss vorliegt

e) weiteres Ausführen der Schritte a) bis d) und Überprüfen des Vorzeichens der bis zum aktuellsten Messzeitpunkt berechneten Blindenergie, wobei ein Resultat der Überprüfung um ein drittes Zeitintervall ansprechverzögert und um ein viertes Zeitintervall rückfallverzögert ist, und

f) Entscheiden mindestens aufgrund des Vorzeichens der Blindenergie ob die Erdschlussrichtung als "Vorwärts", im Falle eines positiven Vorzeichens, oder als "Rückwärts", im Falle eines negativen Vorzeichens, gemeldet wird.

3. Verfahren nach Anspruch 1 oder 2, wobei zusätzlich zur Entscheidung aufgrund des Vorzeichens der Wirkenergie oder der Blindenergie eine Überprüfung eines Vorzeichens der Wirk- oder der Blindleistung durch Integration der Produkte der Nullspannung und des Nullstroms über eine Netzperiode, die den aktuellsten Messzeitpunkt einschliesst, durchgeführt wird, wobei die Erdschlussrichtung bei Übereinstimmung der Vorzeichen der Wirkenergie oder Blindenergie und der Leistung bestätigt wird.

4. Verfahren nach einem der vorangehenden Ansprüche, wobei die Summe aus Schritt b) dadurch ermittelt wird, dass bei jeder Berechnung das Produkt, das dem aktuellsten Messzeitpunkt zugeordnet ist, zur Summe aufsummiert wird und ein ältestes Produkt der Summe herausgerechnet wird.

5. Verfahren nach Anspruch 4, wobei die Summe aus einer einstellbaren, konstanten Anzahl von Wertepaaren gebildet wird.

6. Verfahren nach einem der vorangehenden Ansprüche, wobei die Abtastrate vor einer ersten Messung des Nullstroms und der Nullspannung eingestellt wird, insbesondere wobei eine Millisekunde als Abtastrate gewählt wird.

7. Verfahren nach einem der vorangehenden Ansprüche, wobei das erste Zeitintervall und/oder das zweite Zeitintervall vor einer ersten Messung des Nullstroms und der Nullspannung eingestellt wird/werden, insbesondere wobei beide Zeitintervalle 15 ms betragen.

8. Verfahren nach einem der vorangehenden Ansprüche, wobei das dritte Zeitintervall und/oder das vierte Zeitintervall vor einer ersten Messung des Nullstroms und der Nullspannung eingestellt wird/werden, insbesondere wobei beide Zeitintervalle aus einem Bereich zwischen 30 ms und 2000 ms gewählt werden, insbesondere 300 ms für ein kompensiertes Drehstromnetz oder 50 ms für ein isoliertes Drehstromnetz.

9. Verfahren nach einem der vorangehenden Ansprüche, wobei der erste und/oder der zweite Schwellwert vor einer ersten Messung des Nullstroms und der Nullspannung eingestellt wird/werden.

10. Verfahren nach einem der vorangehenden Ansprüche, **dadurch gekennzeichnet, dass** die Meldung durch das Setzen oder Nichtsetzen von Vorwärts-Flaggen bzw. Rückwärts-Flaggen in einem Speicher durchgeführt wird.

11. Vorrichtung zur Ermittlung eines Erdschlusses und der Erdschlussrichtung in einem kompensiert betriebenen Drehstromnetz, **dadurch gekennzeichnet, dass** die Vorrichtung

mindestens eine Messeinrichtung umfasst, die zum fortlaufenden Messen von Wertepaaren einer Nullspannung und eines Nullstroms, welche Wertepaare jeweils einem Messzeitpunkt zugeordnet sind, mit einer vorgegebenen Abtastrate, ausgestaltet ist, weiter

einen Speicher zum Speichern der ermittelten Wertepaare und des zugeordneten Messzeitpunkts, und

eine Recheneinheit umfasst, wobei die Recheneinheit

- zum fortlaufenden Berechnen der Wirkenergie durch Bildung eines Produkts der gemessenen Nullspannung und des gemessenen Nullstroms jeweils für jeden Messzeitpunkt und Bildung einer Summe aus einem Produkt, das dem aktuellsten Messzeitpunkt zugeordnet ist, und einer Anzahl vorangehender Produkte,

- zum Setzen für den aktuellsten Messzeitpunkt einer Spannungsflagge auf 1 wenn die zugeordnete Nullspannung grösser als ein erster Schwellwert ist und sonst auf 0 und einer Stromflagge auf 1 wenn der zugeordnete Nullstrom grösser als ein zweiter Schwellwert ist und sonst auf 0,

- zum Bilden einer booleschen UND-Verknüpfung aus der Spannungsflagge und der Stromflagge, jeweils für den aktuellsten Messzeitpunkt, wobei ein Resultat der booleschen UND-Verknüpfung um ein erstes Zeitintervall ansprechverzögert und um ein zweites Zeitintervall rückfallverzögert ist, wobei bei einem Resultat gleich 0 kein Erdschluss vorliegt und bei einem Resultat gleich 1 ein Erdschluss vorliegt, und

wenn ein Erdschluss vorliegt

- zum Überprüfen des Vorzeichens der bis zum aktuellsten Messzeitpunkt berechneten Wirkenergie, wobei ein Resultat der Überprüfung um ein drittes Zeitintervall ansprechverzögert und um ein viertes Zeitintervall rückfallverzögert ist, und

- zum Entscheiden mindestens aufgrund des Vorzeichens der Wirkenergie ob die Erdschlussrichtung als "Vorwärts", im Falle eines positiven Vorzeichens, oder als "Rückwärts", im Falle eines negativen Vorzeichens, meldbar ist, ausgestaltet ist.

12. Vorrichtung zur Ermittlung eines Erdschlusses und der Erdschlussrichtung in einem isoliert betriebenen Drehstromnetz, **dadurch gekennzeichnet, dass** die Vorrichtung

mindestens eine Messeinrichtung umfasst, die zum fortlaufenden Messen von Wertepaaren einer Nullspannung und eines Nullstroms, welche Wertepaare jeweils einem Messzeitpunkt zugeordnet sind, mit einer vorgegebenen Abtastrate, ausgestaltet ist, weiter

einen Speicher zum Speichern der ermittelten Wertepaare und des zugeordneten Messzeitpunkts, und

eine Recheneinheit umfasst, wobei die Recheneinheit

- zum fortlaufenden Berechnen der Blindenergie durch Bildung eines Produkts der gemessenen Nullspannung und des gemessenen Nullstroms jeweils für jeden Messzeitpunkt und Bildung einer Summe aus einem Produkt, das dem aktuellsten Messzeitpunkt zugeordnet ist, und einer Anzahl vorangehender Produkte,

- zum Setzen für den aktuellsten Messzeitpunkt einer Spannungsflagge auf 1 wenn die zugeordnete Nullspannung grösser als ein erster Schwellwert ist und sonst auf 0 und einer Stromflagge auf 1 wenn der zugeordnete Nullstrom grösser als ein zweiter Schwellwert ist und sonst auf 0,

- zum Bilden einer booleschen UND-Verknüpfung aus der Spannungsflagge und der Stromflagge, jeweils für den aktuellsten Messzeitpunkt, wobei ein Resultat der booleschen UND-Verknüpfung um ein erstes Zeitintervall ansprechverzögert und um ein zweites Zeitintervall rückfallverzögert ist, wobei bei einem Resultat gleich 0 kein Erdschluss vorliegt und bei einem Resultat gleich 1 ein Erdschluss vorliegt, und

wenn ein Erdschluss vorliegt

- zum Überprüfen des Vorzeichens der bis zum aktuellsten Messzeitpunkt berechneten Blindenergie, wobei ein Resultat der Überprüfung um ein drittes Zeitintervall ansprechverzögert und um ein viertes Zeitintervall rückfallverzögert ist, und

- zum Entscheiden mindestens aufgrund des Vorzeichens der Blindenergie ob die Erdschlussrichtung als "Vorwärts", im Falle eines positiven Vorzeichens, oder als "Rückwärts", im Falle eines negativen Vorzeichens, meldbar ist, ausgestaltet ist.

13. Verwendung der Vorrichtung nach Anspruch 11 oder 12 für die Ermittlung eines intermittierenden oder hochohmigen Erdschlusses und der Erdschlussrichtung in einem kompensiert oder isoliert betriebenen Drehstromnetz.

## Claims

1. Method for ascertaining an earth fault and the earth-fault direction in a three-phase network operated in a compensated way, **characterized by** the steps of:

a) continuously measuring value pairs of a zero voltage and of a zero current with a given sample rate, wherein the value pairs are each attributed to a measurement time, and recording the determined value pairs and the attributed measurement time,

b) continuously calculating the active energy by forming a product of the measured zero voltage and the measured zero current for each measurement time and forming a sum of a product which is attributed to the current measurement time and a number of preceding products,

c) setting for the current measurement time a voltage flag to 1 if the attributed zero voltage is greater than a first threshold value and else to 0, and a current flag to 1 if the attributed zero current is greater than a second threshold value and else to 0,

d) performing a Boolean AND-operation with the voltage flag and the current flag, for each current measurement time, wherein a result of the Boolean AND-operation is ON-delayed by a first time interval and release-delayed by a second time interval, wherein no earth fault is present in case of a result of 0 and an earth fault is present in case of a result of 1, and

if an earth fault is present

e) continuing to execute the steps a) to d) and verifying the algebraic sign of the active energy calculated up to the current measurement time, wherein a result of the verification is ON-delayed by a third time interval and release-delayed by a fourth time interval, and

f) deciding at least on the basis of the algebraic sign of the active energy if the earth fault direction is reported as "forward", in case of a positive algebraic sign, or as "backward" in case of a negative algebraic sign.

2. Method for ascertaining a earth fault and the earth-fault direction in a three-phase network operated in an isolated way, **characterized by** the steps of:

a) continuously measuring value pairs of a zero voltage and of a zero current with a given sample rate, wherein the value pairs are each attributed to a measurement time, and recording the determined value pairs and the attributed measurement time,

b) continuously calculating the reactive energy by forming a product of the measured zero voltage and the measured zero current for each measurement time and forming a sum of a product which is attributed to the current measurement time and a number of preceding products,

c) setting for the current measurement time a voltage flag to 1 if the attributed zero voltage is greater than a first threshold value and else to 0, and a current flag to 1 if the attributed zero current is greater than a second threshold value and else to 0,

d) performing a Boolean AND-operation with the voltage flag and the current flag, for each current measurement time, wherein a result of the Boolean AND-operation is ON-delayed by a first time interval and release-delayed by a second time interval, wherein no earth fault is present in case of a result of 0 and an earth fault is present in case of a result of 1, and

if an earth fault is present

e) continuing to execute the steps a) to d) and verifying the algebraic sign of the reactive energy calculated up to the current measurement time, wherein a result of the verification is ON-delayed by a third time interval and release-delayed by a fourth time interval, and

f) deciding at least on the basis of the algebraic sign of the reactive energy if the earth fault direction is reported as "forward", in case of a positive algebraic sign, or as "backward" in case of a negative algebraic sign.

3. Method according to claim 1 or 2, wherein, additionally to the decision based on the algebraic sign of the active energy or of the reactive energy, a verification of an algebraic sign of the active energy or of the reactive energy is carried out by integrating the products of the zero voltage and of the zero current over a period of the network frequency, which includes the current measurement time, wherein the earth fault direction is confirmed if the algebraic sign of the active energy or the reactive energy and of the power match.

4. Method according to one of the preceding claims, wherein the sum of step b) is determined in such a way that for each calculation the product attributed to the current measurement time is summed up to the sum and an oldest product of the sum is excluded.

5. Method according to claim 4, wherein the sum is calculated with an adjustable constant number of value pairs.

6. Method according to one of the preceding claims, wherein the sample rate is set before a first measurement of the zero current and the zero voltage, particularly wherein a millisecond is chosen as sample rate.

7. Method according to one of the preceding claims, wherein the first time interval and/or the second time interval are/is set before a first measurement of the zero current and of the zero voltage, particularly wherein both time intervals are 15 ms.

8. Method according to one of the preceding claims, wherein the third time interval and/or the fourth time interval are/is set before a first measurement of the zero current and of the zero voltage, particularly wherein both time intervals are chosen from a range between 30 ms and 2000 ms, particularly 300 ms for a compensated three-phase network or 50 ms for an isolated three-phase network.

9. Method according to one of the preceding claims, wherein the first and/or the second threshold value are/is set before a first measurement of the zero current and of the zero voltage.

10. Method according to one of the preceding claims, **characterized in that** the report is issued by setting or not setting forward flags or backward flags, respectively, in a memory.

**11.** Device for ascertaining an earth fault and the earth-fault direction in a three-phase network operated in a compensated way, **characterized in that** the device
comprises at least a measurement device adapted to continuously measure value pairs of a zero voltage and of a zero current with a given sample rate, wherein the value pairs are each attributed to a measurement time, furthermore a memory for storing the determined value pairs and the attributed measurement time, and comprising a calculation unit, wherein the calculation unit is adapted

- to continuously calculate the active energy by forming a product of the measured zero voltage and the measured zero current for each measurement time and to calculate a sum of a product which is attributed to the current measurement time and a number of preceding products,
- to set for the current measurement time a voltage flag to 1 if the attributed zero voltage is greater than a first threshold value and else to 0, and a current flag to 1 if the attributed zero current is greater than a second threshold value and else to 0,
- to perform a Boolean AND-operation with the voltage flag and the current flag, for each current measurement time, wherein a result of the Boolean AND-operation is ON-delayed by a first time interval and release-delayed by a second time interval, wherein no earth fault is present in case of a result of 0 and an earth fault is present in case of a result of 1, and
if an earth fault is present
- to verify the algebraic sign of the active energy calculated up to the current measurement time, wherein a result of the verification is ON-delayed by a third time interval and release-delayed by a fourth time interval, and
- to decide at least on the basis of the algebraic sign of the active energy if the earth fault direction is reported as "forward", in case of a positive algebraic sign, or as "backward" in case of a negative algebraic sign.

**12.** Device for ascertaining an earth fault and the earth-fault direction in a three-phase network operated in an isolated way, **characterized in that** the device
comprises at least a measurement device which is adapted to continuously measure value pairs of a zero voltage and of a zero current with a given sample rate, wherein the value pairs are each attributed to a measurement time, furthermore a memory for storing the determined value pairs and the attributed measurement time, and comprising a calculation unit, wherein the calculation unit is adapted

- to continuously calculate the reactive energy by forming a product of the measured zero voltage and of the measured zero current for each measurement time and to calculate a sum of a product which is attributed to the current measurement time and a number of preceding products,
- to set for the current measurement time a voltage flag to 1 if the attributed zero voltage is greater than a first threshold value and else to 0, and a current flag to 1 if the attributed zero current is greater than a second threshold value and else to 0,
- to perform a Boolean AND-operation with the voltage flag and the current flag, for each current measurement time, wherein a result of the Boolean AND-operation is ON-delayed by a first time interval and release-delayed by a second time interval, wherein no earth fault is present in case of a result of 0 and an earth fault is present in case of a result of 1, and
if an earth fault is present
- to verify the algebraic sign of the reactive energy calculated up to the current measurement time, wherein a result of the verification is ON-delayed by a third time interval and release-delayed by a fourth time interval, and
- to decide at least on the basis of the algebraic sign of the reactive energy if the earth fault direction is reported as "forward", in case of a positive algebraic sign, or as "backward" in case of a negative algebraic sign.

**13.** Use of the device according to claim 11 or 12 for determining an intermittent or high-impedance earth fault and the earth fault direction in a three-phase network operated in a compensated way or in an isolated way.

**Revendications**

**1.** Procédé pour déterminer un défaut à la terre et la direction du défaut à la terre dans un réseau triphasé opéré de manière compensée, **caractérisé par** les étapes:

a) de mesurer de manière continue des paires de valeurs d'une tension nulle et d'un courant nul avec un taux d'échantillonnage donné, les paires de valeurs étant chacune attribuées à un instant de mesure, et d'enregistrer les paires de valeurs déterminées et l'instant de mesure attribué,

b) de calculer de manière continue l'énergie active en formant un produit de la tension nulle mesurée et du courant nul mesuré pour chaque instant de mesure et de former une somme d'un produit attribué à l'instant actuel de mesure et un nombre de produits antécédents,

c) pour l'instant actuel de mesure de fixer un indicateur de tension à 1 si la tension nulle attribuée est supérieure à une première valeur de seuil et autrement à 0, et un indicateur de courant à 1 si le courant nul attribuée est supérieure à une deuxième valeur de seuil et autrement à 0,

d) d'exécuter une opération ET booléenne avec l'indicateur de tension et l'indicateur de courant, pour chaque instant actuel de mesure, un résultat de l'opération ET booléenne étant enclenchement-retardé par un premier intervalle de temps et déclenchement-retardé par un deuxième intervalle de temps, aucun défaut à la terre n'étant présent en cas d'un résultat de 0 et un défaut à la terre étant présent en cas d'un résultat de 1, et si un défaut à la terre est présent

e) de continuer à exécuter les étapes a) à d) et de vérifier le signe algébrique de l'énergie active calculée jusqu'à l'instant actuel de mesure, un résultat de la vérification étant enclenchement-retardé par un troisième intervalle de temps et déclenchement-retardé par un quatrième intervalle de temps,

et

f) de décider au moins à la base du signe algébrique de l'énergie active si la direction du défaut à la terre est signalée d'être « en avant », en cas d'un signe algébrique positif, ou « en arrière » en cas d'un signe algébrique négatif.

2. Procédé pour déterminer un défaut à la terre et la direction du défaut à la terre dans un réseau triphasé opéré de manière isolée, **caractérisé par** les étapes:

a) de mesurer de manière continue des paires de valeurs d'une tension nulle et d'un courant nul avec un taux d'échantillonnage donné, les paires de valeurs étant chacune attribuées à un instant de mesure, et d'enregistrer les paires de valeurs déterminées et l'instant de mesure attribué,

b) de calculer de manière continue l'énergie active en formant un produit de la tension nulle mesurée et du courant nul mesuré pour chaque instant de mesure et de former une somme d'un produit attribué à l'instant actuel de mesure et un nombre de produits antécédents,

c) pour l'instant actuel de mesure de fixer un indicateur de tension à 1 si la tension nulle attribuée est supérieure à une première valeur de seuil et autrement à 0, et un indicateur de courant à 1 si le courant nul attribuée est supérieure à une deuxième valeur de seuil et autrement à 0,

d) d'exécuter une opération ET booléenne avec l'indicateur de tension et l'indicateur de courant, pour chaque instant actuel de mesure, un résultat de l'opération ET booléenne étant enclenchement-retardé par un premier intervalle de temps et déclenchement-retardé par un deuxième intervalle de temps, aucun défaut à la terre n'étant présent en cas d'un résultat de 0 et un défaut à la terre étant présent en cas d'un résultat de 1, et si un défaut à la terre est présent

e) de continuer à exécuter les étapes a) à d) et de vérifier le signe algébrique de l'énergie réactive calculée jusqu'à l'instant actuel de mesure, un résultat de la vérification étant enclenchement-retardé par un troisième intervalle de temps et déclenchement-retardé par un quatrième intervalle de temps,

et

f) de décider au moins à la base du signe algébrique de l'énergie réactive si la direction du défaut à la terre est signalée d'être « en avant », en cas d'un signe algébrique positif, ou « en arrière » en cas d'un signe algébrique négatif.

3. Procédé selon l'une des revendications 1 ou 2, en plus de la décision basée sur le signe algébrique de l'énergie active ou de l'énergie réactive, une vérification d'un signe algébrique de l'énergie active ou de l'énergie réactive étant effectuée en intégrant les produits de la tension nulle et du courant nul pendant une période de la fréquence du réseau, qui inclut l'instant actuel de mesure, la direction du défaut à la terre étant confirmée si le signe algébrique de l'énergie active ou de l'énergie réactive correspond à celui de la puissance.

4. Procédé selon l'une des revendications précédentes, la somme de l'étape b) étant déterminée de sorte que pour caque calcul le produit attribué à l'instant actuel de mesure est ajouté à la somme et le plus vieux produit de la somme est exclus.

5. Procédé selon la revendication 4, la somme étant calculée avec un constant nombre ajustable de paires de valeurs.

6. Procédé selon l'une des revendications précédentes, le taux d'échantillonnage étant fixé avant une première mesure du courant nul et de la tension nulle, particulièrement une milliseconde étant choisie comme taux d'échantillonnage.

**7.** Procédé selon l'une des revendications précédentes, le premier intervalle de temps et/ou le deuxième intervalle de temps étant fixé(s) avant une première mesure du courant nul et de la tension nulle, particulièrement les deux intervalles de temps étant de 15 ms.

**8.** Procédé selon l'une des revendications précédentes, le troisième intervalle de temps et/ou le quatrième intervalle de temps étant fixé(s) avant une première mesure du courant nul et de la tension nulle, particulièrement les deux intervalles de temps étant choisis dans une gamme comprise entre 30 ms et 2000 ms, particulièrement 300 ms pour un réseau triphasé compensé ou 50 ms pour un réseau triphasé isolé.

**9.** Procédé selon l'une des revendications précédentes, la première et/ou la deuxième valeur de seuil étant fixée(s) avant une première mesure du courant nul et de la tension nulle.

**10.** Procédé selon l'une des revendications précédentes, **caractérisé en ce que** le rapport est émis en fixant ou en ne fixant pas des indicateurs pour l'avant ou bien des indicateurs pour l'arrière dans une mémoire.

**11.** Dispositif pour déterminer un défaut à la terre et la direction du défaut à la terre dans un réseau triphasé opéré de manière compensée, **caractérisé en ce que** le dispositif
comprend au moins un dispositif de mesure adapté à mesurer de manière continue des paires de valeurs d'un courant nul et d'une tension nulle avec un taux d'échantillonnage donné, les paires de valeurs étant chacune attribuée à un instant de mesure,
en outre une mémoire pour mémoriser les paires de valeurs déterminées et l'instant de mesure attribué, et comprend une unité de calcul, l'unité de calcul étant adaptée

- à calculer de manière continue l'énergie active en formant un produit de la tension nulle mesurée et du courant nul mesuré pour chaque instant de mesure et à former une somme d'un produit attribué à l'instant actuel de mesure et un nombre de produits antécédents,
- pour l'instant actuel de mesure à fixer un indicateur de tension à 1 si la tension nulle attribuée est supérieure à une première valeur de seuil et autrement à 0, et un indicateur de courant à 1 si le courant nul attribuée est supérieure à une deuxième valeur de seuil et autrement à 0,
- à exécuter une opération ET booléenne avec l'indicateur de tension et l'indicateur de courant, pour chaque instant actuel de mesure, un résultat de l'opération ET booléenne étant enclenchement-retardé par un premier intervalle de temps et déclenchement-retardé par un deuxième intervalle de temps, aucun défaut à la terre n'étant présent en cas d'un résultat de 0 et un défaut à la terre étant présent en cas d'un résultat de 1, et si un défaut à la terre est présent
- à vérifier le signe algébrique de l'énergie active calculée jusqu'à l'instant actuel de mesure, un résultat de la vérification étant enclenchement-retardé par un troisième intervalle de temps et déclenchement-retardé par un quatrième intervalle de temps,
et
- à décider au moins à la base du signe algébrique de l'énergie active si la direction du défaut à la terre est signalée d'être « en avant », en cas d'un signe algébrique positif, ou « en arrière » en cas d'un signe algébrique négatif.

**12.** Dispositif pour déterminer un défaut à la terre et la direction du défaut à la terre dans un réseau triphasé opéré de manière isolée, **caractérisé en ce que** le dispositif
comprend au moins un dispositif de mesure adapté à mesurer de manière continue des paires de valeurs d'un courant nul et d'une tension nulle avec un taux d'échantillonnage donné, les paires de valeurs étant chacune attribuée à un instant de mesure,
en outre une mémoire pour mémoriser les paires de valeurs déterminées et l'instant de mesure attribué, et comprend une unité de calcul, l'unité de calcul étant adaptée

- à calculer de manière continue l'énergie réactive en formant un produit de la tension nulle mesurée et du courant nul mesuré pour chaque instant actuel de mesure et de former une somme d'un produit attribué à l'instant actuel de mesure et un nombre de produits antécédents,
- pour l'instant actuel de mesure à fixer un indicateur de tension à 1 si la tension nulle attribuée est supérieure à une première valeur de seuil et autrement à 0, et un indicateur de courant à 1 si le courant nul attribuée est supérieure à une deuxième valeur de seuil et autrement à 0,
- à exécuter une opération ET booléenne avec l'indicateur de tension et l'indicateur de courant, pour chaque instant actuel de mesure, un résultat de l'opération ET booléenne étant enclenchement-retardé par un premier intervalle de temps et déclenchement-retardé par un deuxième intervalle de temps, aucun défaut à la terre n'étant présent en cas d'un résultat de 0 et un défaut à la terre étant présent en cas d'un résultat de 1, et si un défaut à la terre est présent

- à vérifier le signe algébrique de l'énergie réactive calculée jusqu'à l'instant actuel de mesure, un résultat de la vérification étant enclenchement-retardé par un troisième intervalle de temps et déclenchement-retardé par un quatrième intervalle de temps,

et

- à décider au moins à la base du signe algébrique de l'énergie réactive si la direction du défaut à la terre est signalée d'être « en avant », en cas d'un signe algébrique positif, ou « en arrière » en cas d'un signe algébrique négatif.

13. Utilisation du dispositif selon la revendication 11 ou 12 pour déterminer un défaut à la terre intermittent ou de haute impédance et la direction du défaut à la terre dans un réseau triphasé opéré de manière compensée ou de manière isolée.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

24

Fig. 15

Fig. 16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19901789
- CH 703900
- DE 10302451